Europäisches Patentamt

European Patent Office

Office européen des brevets

(19)

(11) Veröffentlichungsnummer : **0 361 027 B1**

(12) # EUROPÄISCHE PATENTSCHRIFT

(45) Veröffentlichungstag der Patentschrift :
**10.04.91 Patentblatt 91/15**

(51) Int. Cl.⁵ : **B23C 5/10**

(21) Anmeldenummer : **89114158.2**

(22) Anmeldetag : **01.08.89**

---

(54) **Konturenfräser.**

---

(30) Priorität : **30.09.88 DE 3833204**

(43) Veröffentlichungstag der Anmeldung :
**04.04.90 Patentblatt 90/14**

(45) Bekanntmachung des Hinweises auf die
Patenterteilung :
**10.04.91 Patentblatt 91/15**

(84) Benannte Vertragsstaaten :
**BE CH DE ES FR GB IT LI NL SE**

(56) Entgegenhaltungen :
**DE-A- 3 243 522**
**DE-C- 736 449**
**US-A- 3 913 196**

(73) Patentinhaber : **HAWERA
Präzisionswerkzeuge GmbH
Wangener Str. 133
W-7980 Ravensburg (DE)**

(72) Erfinder : **Scheuch, Anton
Kuppelnaustrasse 41
W-7980 Ravensburg (DE)**
Erfinder : **Schmidt, Johann
Schacherstrasse 18
W-7982 Baienfurt (DE)**

(74) Vertreter : **Patentanwälte Dipl.-Ing. E. Eisele
Dr.-Ing. H. Otten
Seestrasse 42
W-7980 Ravensburg (DE)**

**Beschreibung**

Die Erfindung betrifft ein spanabhebendes Werkzeug, insbesondere einen Konturenfräser zur Bearbeitung von Leiterplatten o.dgl. nach dem Oberbegriff des Anspruchs 1 ; siehe beispielsweise DE-A 32 43 522.

Zur spanabhebenden Bearbeitung insbesondere von glasfaserverstärkten Leiterplatten sind Konturenfräser bekannt geworden, die üblicherweise aus Vollhartmetall mit pyramidenähnlicher Zahnform und einem Durchmesser von 0,4 bis 3 mm bestehen. Die Einsatzdauer bzw. der Standweg des Werkzeugs wird im wesentlichen von der Beschaffenheit des zu bearbeitenden Werkstoffes sowie von der Schneidengeometrie der einzelnen Schneiden des Fräsers bestimmt. Bei der Schneidengeometrie wird eine sog. Kreuzverzahnung oder auch Diamantverzahnung angewandt. Hierzu wird das Werkzeug mit einer bestimmten Anzahl von Hauptschneidnuten mit Hauptschneiden mit einer bestimmten Steigung versehen, die von einer bestimmten Anzahl von Teilernuten oder Nebenschneidnuten mit gegenläufiger Steigung gekreuzt werden. Durch die Teilernuten werden die Hauptschneidnuten in Teilbereiche aufgeteilt, so daß jede, zunächst durchgehende Hauptschneide in eine Vielzahl von Einzelschneidelementen mit geringer Breite durch die Teilernuten unterteilt ist. Dies ist erforderlich, um die Schneidenbelastung und die Erwärmung der Konturenfräser herabzusetzen, um die Bruchgefahr zu reduzieren.

Bei der Herstellung der Kreuzverzahnung, bestehend aus Hauptschneidnuten und gegenläufigen Teilernuten wurden bisher folgende Kriterien beachtet. Sofern man die Anzahl und den Steigungswinkel von Hauptschneidnuten und Teilernuten in ihrem Betrag gleich auswählt, ergeben sich axiale Lücken, die keinen Schneidzahn aufweisen. Deshalb scheidet diese Methode bei der Herstellung der Kreuzverzahnung im allgemeinen aus.

Um keine axialen Lücken im Schneidbereich zu erhalten, sieht eine Methode der Herstellung von Kreuzverzahnungen vor, daß die Anzahl der Hauptschneidnuten unterschiedlich gewählt wird zur Anzahl der Teilernuten, bei gleichbleibendem Steigungswinkel beider Nutenarten. Wählt man beispielsweise eine Differenz von "1" zwischen Anzahl der Hauptschneidnuten und Teilernuten, z.B. sieben Hauptschneidnuten und acht Teilernuten bei gleicher Steigung, so ergibt sich in einer axialen Höhe, d. h. in einer radialen Ebene ein Einzelschneidelement am gesamten Umfang, dem sich axial gesehen, ein weiteres Einzelschneidelement anschließt, welches am Umfang um einen bestimmten Winkel versetzt ist, wobei keine Überlappung der Schneidzähne in axialer Richtung stattfindet.

Wählt man eine Differenz zwischen Anzahl der Hauptschneidnuten und Teilernuten von "2", z.B. acht Hauptschneidnuten und zehn Teilernuten, so ergibt dies ein Fräswerkzeug, bei welchem in einer axialen Höhe, d.h. in einer radialen Ebene zwei Einzelschneidelemente um einen bestimmten Winkel versetzt angeordnet sind. Auch hier schließen sich die weiteren, in einer anderen axialen Lage angeordneten Schneidelemente lediglich an, ohne daß es zu einer axialen Überlappung einzelner Schneidelemente kommt. In Fig. 5 ist eine Abwicklung des Schneidmantels eines solchen Konturenfräsers gezeigt. Dabei sind acht Hauptschneidnuten und zehn Teilernuten gewählt. Der senkrechte gestrichelte Bereich zeigt den jeweiligen Teilbereich des Anfangs und Endes zweier axial aufeinander folgenden Zähnen mit direktem Eckenanschluß. Dies wird nachfolgend noch näher beschrieben.

Wählt man gleiche Anzahl von Hauptschneidnuten und Teilernuten bei unterschiedlichen Steigungswinkeln der beiden Nutenarten, so ergibt dies zwar in einer bestimmten axialen Höhe, d.h. einer bestimmten radialen Ebene, eine Vielzahl von Schneidelementen, die je nach Größe der Steigungsdifferenzen axial versetzt gegeneinander angeordnet sind. Eine Vielzahl von in der gleichen radialen Ebene angeordneten Schneidelementen erhöht jedoch die Reibungskräfte und vermindert den Schneiddruck auf den einzelnen Schneidzahn bzw. Einzelschneidelement. Deshalb ist auch diese Herstellungsmethode unbefriedigend.

Der Erfindung liegt die Aufgabe zugrunde, eine verbesserte Schneidengeometrie eines spanabhebenden Fräswerkzeuges, insbesondere eines Konturenfräsers zur Bearbeitung von Leiterplatten zu schaffen, wobei die Belastung insbesondere der Eckbereiche der Schneidzähne reduziert und damit die Standzeiten erhöht werden, bei Erhöhung der Schneidleistung und Verminderung der Wärmeentwicklung.

Diese Aufgabe wird ausgehend von einem Werkzeug der einleitend bezeichnenden Art erfindungsgemäß durch die kennzeichnenden Merkmale des Anspruchs 1 gelöst.

Der Erfindung liegt die Erkenntnis zugrunde, daß ein optimaler Wirkungsgrad des Konturenfräsers dann erzielt wird, wenn in einer axialen Höhe, d.h. in einer Radialebene lediglich ein Schneidzahn oder Einzelschneidelement der Hauptschneide in spanabhebenden Eingriff kommt, da hierdurch ein Maximum an Zerspanfähigkeit bei einem Minimum an Wärmeentwicklung verwirklicht wird. Schon zwei Schneidzähne am Umfang bzw. auf der gleichen Radialebene erhöhen die Wärmeentwicklung erheblich, was zu einem vorzeitigen Verschleiß führt. Erfindungsgemäß wird jedoch das in einer radialen Ebene angeordnete Einzelschneidelement bzw. der Schneidzahn von einem weiteren, axial etwas versetzt angeordneten Schneidzahn bzw. Einzelschneidelement überlappt, wobei die Überlappung etwa bis zur Hälfte der Breite jedes Schneidzahnes erfolgen kann. Dabei ist der axial überlappende Schneidzahn am Umfang um einen bestimmten Winkel versetzt angeordnet. Je nach Breite der gewählten Hauptschneidnuten und/oder Teilernuten kann die Überlappung in bestimmtem Umfang variiert werden.

Die Überlappung der Einzelschneidelemente bzw. diese Zahnüberdeckung hat den Vorteil, daß diese Einzelschneidelemente in ihren Eckbereichen nicht derart stark beansprucht werden, wie es der Fall ist, wenn die Einzelschneidelemente sich axial aneinander ohne Überlappung anschließen. Gerade die Eckbereiche der Schneidzähne sind besonders verschleißempfindlich, so daß die erfindungsgemäße Ausbildung zu einer beträchtlichen Erhöhung der Standzeiten und zu einer Leistungssteigerung führt. Bei einer Schnittgeschwindigkeit zwischen 220 m/Min. und 260 m/Min. ist beispielsweise eine Leistungssteigerung bis zu 70% gemessen worden. Gleichzeitig konnte die Standzeit um 25% erhöht werden.

Maßgeblich für die erfindungswesentliche Geometrie des Konturenfräsers ist die Auswahl der Anzahl der Hauptschneidnuten sowie der zugehörigen Teilernuten. Wählt man die Anzahl der Hauptspannuten als mathematische Primzahl, d.h. als Zahl, die nur mit sich selbst und der Zahl "1" teilbar ist, wählt man weiterhin die Anzahl der Teilernuten in einem bestimmten Verhältnis zu der gewählten Primzahl, insbesondere zuzüglich zwei Nuten, so ergibt sich die erfindungsgemäße Fräsergeometrie mit vorzugsweise nur einem in einer radialen Ebene d.h. einer axialen Höhe angeordneten Schneidzahn bzw. Einzelschneidelement an der Hauptschneide und einem sich mit diesem Schneidzahn axial überlappenden weiteren Schneidzahn. Die Zahnüberdeckung ist dabei 1 1/2fach +/- 0,1 fach ausgebildet.

Besonders vorteilhaft ist die Wahl der primzahl "7" für die Anzahl der Hauptschneidnuten und "9" für die Teilernuten, bei einem gleichen Spiralsteigungswinkel von $\alpha_1 = \alpha_2 \sim 22$ bis 24° für die Hauptschneidnuten und die Teilernuten. Hierdurch ergibt sich ein Werkzeug mit einer hohen Leistungssteigerung.

Vorteilhaft ist dabei weiterhin, wenn der Steigungswinkel $\beta$ der in der Abwicklung aufeinander folgenden Einzelschneiden der Hauptschneidnut einen Winkel in der Größe $\beta \sim 71$ bis 74° zur Werkzeugachse einnimmt. Zweckmäßigerweise werden die Nutentiefen der Hauptschneidnut und der Teilernut in der Größenordnung von 12 bis 16% vom Nenndurchmesser gewählt. Dies ergibt eine ausreichende Nutentiefe für den Abtransport des Spangutes, ohne daß der Zahnfuß und der Kerndurchmesser zu sehr geschwächt sind.

Das Fräswerkzeug kann links- oder rechtsspiralig je nach Anwendungsfall ausgestattet sein.

Bei der erfindungsgemäßen Zahngeometrie läßt sich die Breite der Einzelschneidelemente bzw. jedes einzelnen Schneidzahnes aus der in der Beschreibung angegebenen Formel näher berechnen. Auf diese Weise, sowie in Verbindung mit der Nutenbreite, läßt sich die Zahngeometrie des Fräsers genau bestimmen.

Um die hohe Leistungssteigerung zu erzielen, wird vorzugsweise ein Werkstoff aus Ultrafeinkorn-Hartmetall mit einer Korngröße von $\sim 0{,}4\mu$ gewählt, bei einer Vickershärte von HV > 1800, insbesondere HV = 2.000 N/mm² bei einer Bruckfestigkeit von $\delta$ B > 2.800 N/mm².

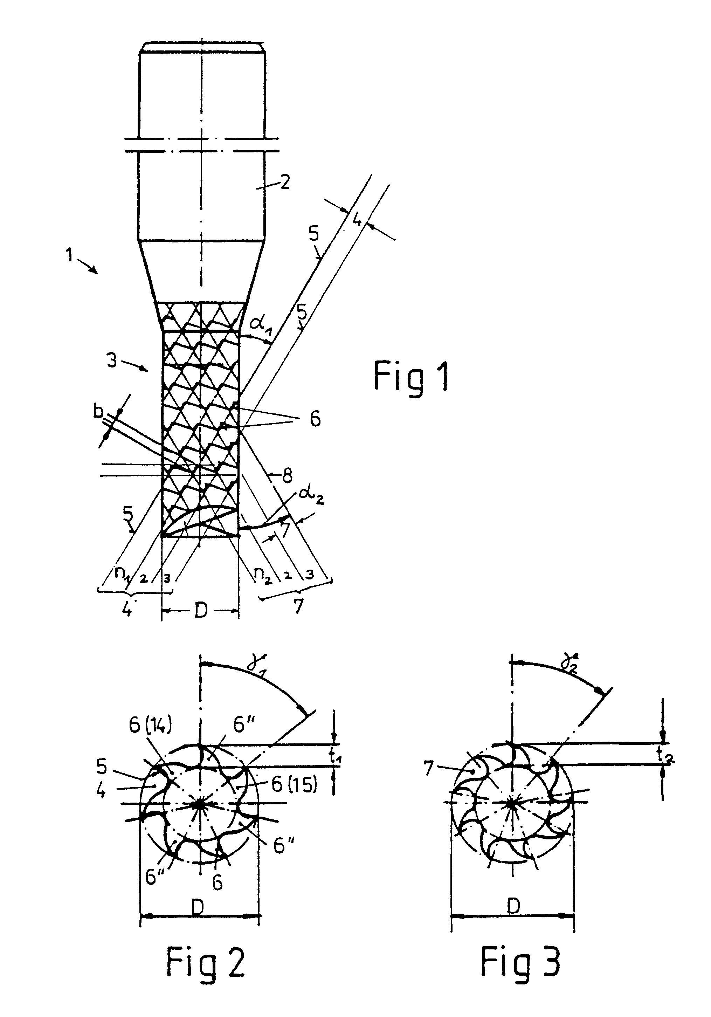

Weitere Einzelheiten und Vorteile der Erfindung ergeben sich aus der nachfolgenden Figurenbeschreibung eines bekannten Fräswerkzeugs (Fig. 1 und 5) sowie eines Ausführungsbeispiels der Erfindung (Fig. 2 bis 4).

In Figur 1 ist zur Erklärung der Begriffe ein bekanntes Fräswerkzeug schematisch dargestellt. Das Fräswerkzeug 1 besteht aus einem Einspannschaft 2 und einem Schneidenteil 3 mit einer sog. Kreuzverzahnung. In Verbindung mit der Darstellung nach Fig. 5, welche eine Abwicklung des Schneidenteils mit Kreuzverzahnung in bekannter Form darstellt, werden in das Schneidenteil 3 beispielsweise $n_1$ = 8 nebeneinanderliegende Hauptschneidnuten 4 unter einem Steigungswinkel $\alpha_1$ zur Bildung der Hauptschneiden 5 eingebracht.

Um die spiralförmig verlaufenden Hauptschneiden 5 in ihrer Länge zu unterbrechen bzw. um die Einzelschneidelemente bzw. Schneidzähne 6 herzustellen, werden sog. Teilernuten 7 unter einem gegenläufigen Winkel $\alpha_2$ eingebracht. In der Darstellung nach Fig. 5 sind dies bei einem bekannten Fräswerkzeug $n_2$ = 10 Teilernuten. Die Teilernuten bilden eine Nebenschneide 8, die jedoch nicht als eigentliche Schneide wirkt.

Betrachtet man das in Fig. 1 nur schematisch dargestellte Schneidenteil 3 am Beispiel eines bekannten Fräsers nach Fig. 5 mit einem Verhältnis $n_1 : n_2$ = 8 : 10 bei einem Steigungswinkel der Hauptschneidnuten und Nebenschneidnuten von $\alpha_1 = \alpha_2$, so stellt man in jeder axialen Höhe bzw. radialen Ebene 9, 9' usw. fest, daß stets zwei Einzelschneidelemente 6, 6' am Umfang im jeweiligen Höhenabschnittsbereich (z.B. 10) am Umfang der Kreuzverzahnung verteilt sind. Der in axialer Richtung darauffolgende Schneidzahn liegt in der Darstellung nach Fig. 5 im nächstfolgenden Höhenabschnittsbereich 11, oberhalb oder unterhalb des Höhenabschnittsbereiches 10, so daß es zu keiner Überlappung der Schneidzähne 6, 6' sondern lediglich zu einem axialen Anschluß durch die sich anschließenden Höhenabschnittsbereiche kommt. In Fig. 5 sind zur besseren Darstellung noch zwei weitere Höhenabschnittsbereiche 12, 13 dargestellt, wobei jeder Höhenabschnittsbereich 10 bis 13 und folgende stets die Breite b' der Schneidzähne 6, 6' in ihrer seitlichen Projektion aufweist. Die tatsächliche Breite ist mit "b" gekennzeichnet.

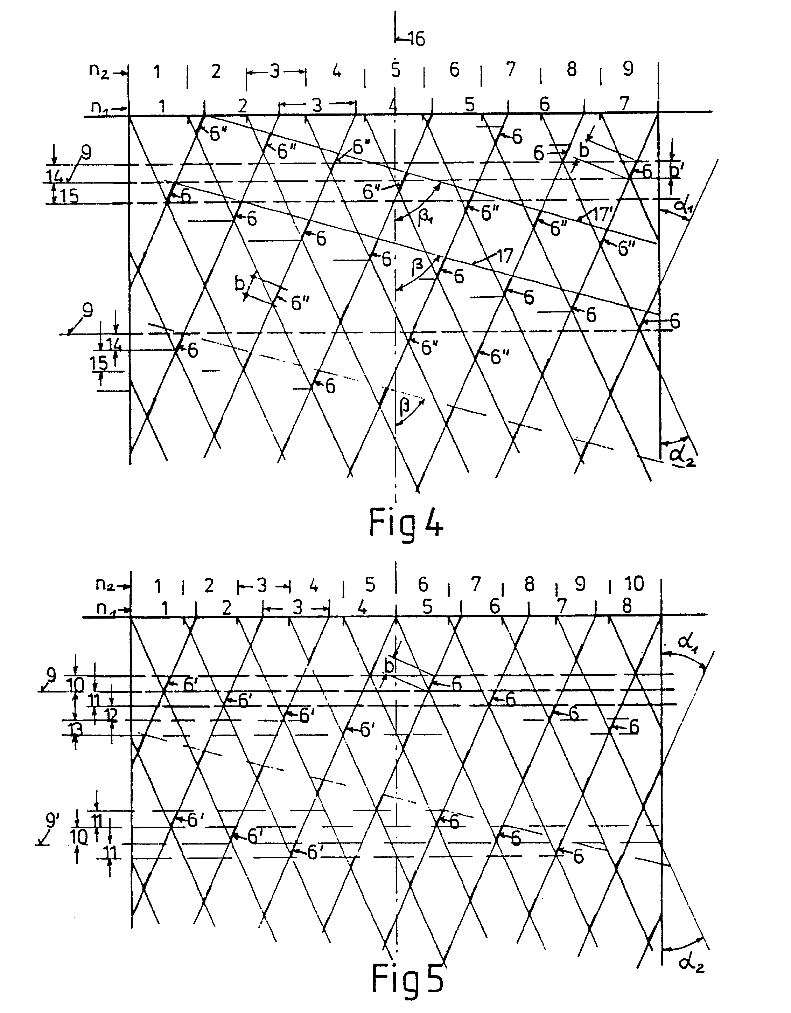

Bei der vorliegenden Erfindung wird nun in einem bevorzugten Ausführungsbeispiel die für die Anzahl der Hauptschneidnuten zu verwendende Primzahl als $n_1 = 7$ und die Anzahl der Teilernuten $n_2 = 9$ gewählt, wie dies im Ausführungsbeispiel der Erfindung nach Fig. 4 dargestellt ist. Dabei beträgt der Spiralsteigungswinkel $\alpha_1 = \alpha_2$ ca. 22 bis 24°, insbesondere $\alpha_1 = \alpha_2 = 23°$.

Aus der zeichnerischen Darstellung der Abwicklung in Fig. 4 zeigt sich, daß in einem bestimmten axialen Höhenabschnittsbereich 14, d.h. in einer bestimmten axialen Höhe bzw. radialen Ebene 9 lediglich ein einziges Einzelschneidelement 6 (Schneidzahn) mit der Breite "b" und seiner vollen seitlichen Projektionsbreite b', welches dem Höhenabschnittsbereich 14 entspricht, vorhanden ist. Auch der darauffolgende nächste Höhenabschnittsbereich 15 weist lediglich einen Schneidzahn 6 an seinem gesamten Umfang auf.

Erfindungsgemäß werden jedoch aufeinanderfolgende Höhenabschnittsbereiche 14, 15 von diesen Bereichen überlappende Schneidzähne 6″ überbrückt, wobei jeder Schneidzahn 6 innerhalb eines Höhenabschnittes 14, 15 etwa zu 50% vom Schneidzahn 6″ aus dem benachbarten Höhenabschnitt überlappt wird. Es liegt demnach eine 1 1/2fache Zahnüberdeckung vor, die vorzugsweise um das +/– 0,1 fach variieren kann.

Die Breite b jedes Einzelschneidelements bzw. jedes Schneidzahns 6, 6′, 6″ berechnet sich aus der Formel

$$b = \frac{D \cdot \pi}{\tan \alpha} \cdot \frac{1}{n_1 \cdot n_2}$$

Hierbei ist :
D =    Nenndurchmesser des Schneidenteils
$\alpha$ =    $\alpha_1 = \alpha_2$ = Steigungswinkel von Hauptschneidennut 4 und Teilernut 7
$n_1$ =    Anzahl der Hauptschneidnuten 4
$n_2$ =    Anzahl der Teilernuten 7

Die axial aufeinanderfolgenden, jedoch am Umfang versetzt angeordneten Schneidzähne 6 in jedem Höhenabschnittsbereich 14, 15 usw. liegen auf einer Linie 17 mit dem Steigungswinkel $\beta$ zwischen 74 und 71° zur Werkzeuglängsachse 16. Gleichermaßen liegen die Schneidzähne 6″, die die Schneidzähne 6 stets um die Hälfte überlappen, ebenfalls auf einer Linie 17′ einem Steigungswinkel $\beta_1$, wobei $\beta_1 = \beta$ ist.

Aus der Darstellung nach Fig. 4 ist demnach ersichtlich, daß in jeder axialen Höhe bzw. jeder radialen Ebene 9 stets nur ein einziger Schneidzahn 6 vorhanden ist, der - axial gesehen - vom nächstfolgenden Zahn 6″ zur Hälfte überdeckt ist. Dies gilt in beiden axialen Richtungen des Schneidzahns. In Fig. 4 sind die axial sich anschließenden, d.h. sich nicht überlappenden Schneidzähne mit 6, und die zu diesen Schneidzähnen überlappenden Zähne mit 6″ bezeichnet.

Durch die Zahnüberdeckung werden die Zahnecken weniger stark beansprucht. Im übrigen liegt eine hohe Schneidleistung vor, da sich in jeder radialen Ebene nur ein ganzer Schneidzahn befindet.

Für die Erfindung ist es demnach wesentlich, daß für die Anzahl $n_1$ der Hauptschneidnuten eine Primzahl verwendet wird. Dies ist im Ausführungsbeispiel nach Fig. 4 die Primzahl "7". Folgendes Verhältnis von Anzahl der Hauptschneidnuten zu den Teilernuten wäre sinnvoll :

| $n_1$ | 5 | 7 | 11 | 13 |
|-------|---|---|----|----|
| $n_2$ | 7 | 9 | 13 | 15 |

Bei der Wahl einer Primzahl als Anzahl für die Hauptschneidnuten ergeben sich die zuvor geschilderten Fräsereigenschaften, wobei stets eine Überlappung der Schneidzähne eintritt. Die Stärke bzw. der Umfang der Überlappung wird durch die Breite der Teilernut in gewissem Umfang bestimmt.

In Fig. 2 sind zur Vervollständigung der Darstellung noch eine Stirnansicht der Hauptschneide mit den Schneidzähnen 6 sowie den axial hierzu versetzt angeordneten Schneidzähnen 6″ dargestellt. Hinter dem Schneidzahn 6 ist der zugehörige Höhenabschnittsbereich 14, 15 usw. in Klammern angegeben; z.B. 6 (14) : Schneidzahn 6 im Höhenabschnittsbereich 14. Die in Fig. 2 dargestellten Schneidzähne 6 liegen selbstverständlich in unterschiedlichen axialen Höhen bzw. radialen Ebenen, wobei diese Ebenen in Fig. 4 wiedergegeben sind.

Der Teilungswinkel beträgt $\delta 1 = \frac{360}{n_1}$

Bei sieben Hauptschneidnuten beträgt $\delta_1 = 51°$ 25′ 43″. Die Tiefe der Hauptschneidnut ist mit $t_1$ angegeben, wobei diese 12 bis 16% des Nenndurchmessers D des Fräswerkzeugs beträgt.

In Fig. 3 ist eine Stirnansicht der Nebenschneiden dargestellt, hervorgerufen durch die Teilernuten 7. Der Teilungswinkel beträgt

$$\delta 2 = \frac{360°}{n_2}$$

Bei $n_2 = 9$ Teilernuten $\delta_2 = 40°$. Die Nutentiefe $t_2$ der Teilernuten 7 liegt in der gleichen Größenordnung wie die Nutentiefe $t_1$ der Hauptschneidnuten 5, insbesondere gilt $t_1 = t_2$.

Die Erfindung ist nicht auf das dargestellte und beschriebene Ausführungsbeispiel beschränkt. Sie umfaßt im Rahmen der Patentansprüche auch alle

fachmännischen Abwandlungen.

## Ansprüche

1. Konturenfräser, insbesondere zur Bearbeitung von Leiterplatten o.dgl., mit einem Schneidenteil mit Kreuzverzahnung (Diamantverzahnung), die durch eine Anzahl ($n_1$) von in einem bestimmen Steigungswinkel ($\alpha_1$) verlaufenden Hauptschneidnuten gebildet ist, deren Hauptschneiden durch eine Anzahl ($n_2 = n_1 + X$) von, die Hauptschneidnuten kreuzenden Teilernuten mit einem Steigungswinkel $\alpha_2$ unterbrochen sind, wobei der Spiralsteigungswinkel $\alpha_1$ der Hauptschneidnuten im Betrag gleich dem Steigungswinkel ($\alpha_2$) der Teilernuten ist, dadurch gekennzeichnet, daß zur Bildung von sich axial überlappenden Schneidzähnen (6, 6″) die Anzahl ($n_1$) der Hauptschneidnuten (4) einer Primzahl entspricht ($n_1 = 3, 5, 7, 11, 13...$) und daß die Anzahl ($n_2$) der Teilernuten (7) größer ist als die Anzahl $n_1$ der Hauptschneidnuten (4) und um den Betrag "2" höher liegt ($n_2 = n_1 + 2$) als die Anzahl ($n_1$) der Hauptschneidnuten.

2. Konturenfräser nach Anspruch 1, dadurch gekennzeichnet, daß sich zwei am Umfang versetzt angeordnete Schneidzähne (6) in axialer Richtung aneinander anschließen und daß die axiale Überlappung dieser Schneidzähne (6) durch einen axial dazwischenliegenden Zahn (6″) erfolgt.

3. Konturenfräser nach Anspruch 1, dadurch gekennzeichnet, daß die Spiralsteigungswinkel $\alpha_1, \alpha_2$ der Hauptschneidnuten (4) und der Teilernuten (7) $\alpha_1 = \alpha_2 \sim 22$ bis 24°, insbesondere $\alpha_1 = \alpha_2 = 23°$ beträgt bei einer Anzahl $n_1 = $ "7" der Hauptschneidnuten (4) und $n_2 = $ "9" der Teilernuten (7).

4. Konturenfräser nach Anspruch 1 oder 2, dadurch gekennzeichnet, daß die durch die Teilernuten (7) gebildeten Einzelschneidelemente bzw. Schneidzähne (6, 6″) der Hauptschneide (5) auf einem Steigungswinkel $\beta$ zwischen 74° und 71° zur Werkzeuglängsachse (16) am Schneidenhüllzylinder angeordnet sind.

5. Konturenfräser nach einem oder mehreren der vorhergehenden Ansprüche, dadurch gekennzeichnet, daß die Tiefe ($t_1$) der Hauptschneidnut (4) und die Tiefe ($t_2$) der Teilernut (7) ca. 12 bis 16% des Werkzeugnenndurchmessers (D) betragen ($t_1 = t_2 \sim (12$ bis $16\%) \cdot D$)).

6. Konturenfräser nach einem oder mehreren der vorhergehenden Ansprüche, dadurch gekennzeichnet, daß die Hauptschneidnut (4) und die Teilernut (7) links- oder rechtsspiralig ausgebildet ist.

7. Konturenfräser nach einem oder mehreren der vorhergehenden Ansprüche, dadurch gekennzeichnet, daß sich die Breite (b) eines Einzelschneidelements (6, 6″) (Schneidzahn) der Hauptschneidnut (4) aus der Formel ergibt:

$$b = \frac{D \cdot \pi}{\tan \alpha} \cdot \frac{1}{n_1 \, n_2}$$

wobei D = Nenndurchmesser

$\alpha = \alpha_1 = \alpha_2 = $ Steigungswinkel von Hauptschneidnut und Teilernut

$n_1 = $ Anzahl der Hauptschneidnuten

$n_2 = $ Anzahl der Teilernuten ist.

8. Konturenfräser nach einem oder mehreren der vorhergehenden Ansprüche, dadurch gekennzeichnet, daß er aus einem Ultrafeinkorn-Hartmaterial mit einer Korngröße von ca. $0,4\mu$ besteht mit einer Vickershärte von HV > 1800 N/mm², insbesondere HV = 2000 N/mm² und einer Bruchfestigkeit von $\delta_B > 2800$ N/mm².

## Claims

1. Contour milling cutter, in particular for the machining of circuit boards or the like, with a cutting member having cross teeth (diamond teeth) formed by a number ($n_1$) of main cutting grooves which extend at a specific angle of inclination ($\alpha_1$) and of which the main cutting members are interrupted by a number ($n_2 = n_1 + X$) of dividing grooves intersecting the main cutting grooves, with an angle of inclination ($\alpha_2$), wherein the spiral angle of inclination ($\alpha_1$) of the main cutting grooves is equal in amount to the angle of inclination ($\alpha_2$) of the dividing grooves, characterised in that, to form axially overlapping cutting teeth (6, 6″) the number ($n_1$) of main cutting grooves (4) corresponds to a prime number ($n_1 = 3, 5, 7, 11, 13...$) and that the number ($n_2$) of dividing grooves (7) is greater than the number ($n_1$) of main cutting grooves (4) and is higher by the amount "2" ($n_2 = n_1 + 2$) than the number ($n_1$) of main cutting grooves.

2. Contour milling cutter according to claim 1, characterised in that two cutting teeth (6) which are offset on the periphery follow one another in an axial direction and in that the axial overlap of these cutting teeth (6) is produced by an axially interposed tooth (6″).

3. Contour milling cutter according to claim 1, characterised in that the spiral angle of inclination ($\alpha_1, \alpha_2$) of the main cutting grooves (4) and the dividing grooves (7) is $\alpha_1 = \alpha_2 \sim 22$ to 24°, in particular $\alpha_1 = \alpha_2 = 23°$ with a number $n_1 = $ "7" of the main cutting grooves (4) and $n_2 = $ "9" of the dividing grooves (7).

4. Contour milling cutter according to claim 1 or 2, characterised in that the individual cutting elements or cutting teeth (6, 6″) of the main cutting member (5), formed by the dividing grooves (7), are arranged at an angle of inclination $\beta$ of between 74° and 71° to the longitudinal axis of the tool (16) on the cutting member enveloping cylinder.

5. Contour milling cutter according to one or more of the preceding claims, characterised in that the depth ($t_1$) of the main cutting groove (4) and the depth ($t_2$) of the dividing groove (7) are about 12 to 16% of the tool diameter (D) ($t_1 = t_2 \sim (12$ to $16\%) \cdot$ (D)).

6. Contour milling cutter according to one or more of the preceding claims, characterised in that the main cutting groove (4) and the dividing groove (7) is constructed as a left or right spiral.

7. Contour milling cutter according to one or more of the preceding claims, characterised in that the width (b) of an individual cutting element (6, 6″) (cutting tooth) of the main cutting groove (4) follows from the formula

$$b = \frac{D \cdot \pi}{\tan \alpha} \cdot \frac{1}{n_1 \, n_{2)}}$$

wherein D = nominal diameter
$\alpha = \alpha_1 = \alpha_2$ = angle of inclination of main cutting groove and dividing groove
$n_1$ = number of main cutting grooves
$n_2$ = number of dividing grooves.

8. Contour milling cutter according to one or more of the preceding claims characterised in that it consists of an ultrafine grain hard material with a grain size of about 0.4µ and a Vickers hardness of HV > 1800 N/mm² in particular HV = 2800 N/mm² and a breaking strenth of $\delta_B$ > 2800 N/mm².

## Revendications

1. Fraise à profiler, en particulier pour l'usinage de plaquettes imprimées ou analogues, comportant une partie de coupe à denture étagée (denture diamant), qui est formée par une pluralité ($n_1$) de gorges de tranchants principaux s'étendant sous un angle d'inclinaison déterminé ($\alpha_1$), dont les tranchants principaux ou arêtes de coupe sont interrompus par une pluralité ($n_2 = n_1 + x$) de gorges de séparation, croisant les gorges des tranchants principaux, sous un angle d'inclinaison ($\alpha_2$), l'angle d'inclinaison ($\alpha_1$) des gorges des tranchants principaux étant de même valeur que l'angle d'inclinaison ($\alpha_2$) des gorges de séparation, caractérisée en ce que, pour former des dents de coupe se chevauchant axialement (6,6″), le nombre ($n_1$) des gorges (4) des tranchants principaux correspond à un nombre premier ($n_1 = 3$, 5, 7, 11, 13...), et en ce que le nombre ($n_2$) des gorges de séparation (7) est plus grand que le nombre ($n_1$) des gorges (4) des tranchants principaux et est plus élevé de la valeur "2" ($n_2 = n_1 + 2$) que le nombre ($n_1$) des gorges des tranchants principaux.

2. Fraise à profiler selon la revendication 1, caractérisée en ce que deux dents de coupe (6) agencées de façon périphériquement décalée se raccordent l'une à l'autre en direction axiale, et en ce que le chevauchement axial de ces dents de coupe (6) est réalisé par une dent (6″) qui se trouve axialement entre elles.

3. Fraise à profiler selon la revendication 1, caractérisée en ce que les angles d'inclinaison ($\alpha_1, \alpha_2$) des gorges (4) des tranchants principaux et des gorges de séparation (7) sont $\alpha_1 = \alpha_2 \sim 22$ à 24°, en particulier $\alpha_1 = \alpha_2 = 23$°, pour un nombre $n_1 = 7$ des gorges (4) des tranchants principaux et $n_2 = 9$ des gorges de séparation (7).

4. Fraise à profiler selon la revendication 1 ou 2, caractérisée en ce que les dents de coupe ou éléments individuels de coupe (6, 6″), formés par les gorges de séparation (7), des tranchants principaux (5) sont agencés sur un angle d'inclinaison β entre 74° et 71° par rapport à l'axe longitudinal (16) de l'outil sur le cylindre d'enveloppe de coupe.

5. Fraise à profiler selon une ou plusieurs des revendications précédentes, caractérisée en ce que la profondeur ($t_1$) de la gorge (4) de tranchant principal et la profondeur ($t_2$) de la gorge de séparation (7) s'élèvent entre environ 12 et 16% du diamètre nominal de l'outil (D) : $t_1 = t_2 \sim (12$ à 16%). D.

6. Fraise à profiler selon une ou plusieurs des revendications précédentes, caractérisée en ce que la gorge (4) de tranchant principal et la gorge de séparation (7) sont formées en spirale à droite ou à gauche.

7. Fraise à profiler selon une ou plusieurs des revendications précédentes, caractérisée en ce que la largeur (b) d'un élément individuel de coupe (6, 6″) (dent de coupe) de la gorge (4) de tranchant principal est obtenue à partir de la formule :

$$b = \frac{D \cdot \pi}{\mathrm{tg} \alpha} \frac{1}{n_1 \cdot n_2}$$

dans laquelle :
D = diametre nominal
$\alpha = \alpha_1 = \alpha_2$ = angle d'inclinaison de la gorge de tranchant principal et de la gorge de séparation.
$n_1$ = nombre de gorges de tranchants principaux
$n_2$ = nombre de gorges de séparation.

8. Fraise à profiler selon une ou plusieurs des revendications précédentes, caractérisée en ce qu'elle est constituée d'une matière dure à grains ultrafins, ayant une grosseur de grains d'environ 0,4 µ, avec une dureté Vickers supérieure à 1800 N/mm², en particulier égale à 2000 N/mm², et une résistance à la rupture $\delta_B$ > 2800 N/mm².

Fig 1

Fig 2

Fig 3

Fig 4

Fig 5